# EUROPÄISCHE PATENTANMELDUNG

(11) **EP 1 207 553 A1**
(43) Veröffentlichungstag der Anmeldung: **22.05.2002**
(21) Anmeldenummer: 00811084.3
(22) Anmeldetag: 16.11.2000
(51) Int. Cl.: H01L 23/48

(54) **Einspannvorrichtung für ein druckkontaktiertes Hochleistungshalbleiterbauelement**

(71) Anmelder: ABB Schweiz AG, 5400 Baden (CH)
(72) Erfinder: Zeller, Hans-Rudolf, 5242 Birr (CH); Lang, Thomas, 8051 Zürich (CH); Schneider, Daniel, 8032 Zürich (CH)
(74) Vertreter: ABB Patent Attorneys

(57) **Zusammenfassung**

Bei einer Einspannvorrichtung (10) für wenigstens ein Hochleistungshalbleiterbauelement (13), bei welchem Hochleistungshalbleiterbauelement (13) der aktive Halbleiterchip durch beidseitigen Druck von aussen elektrisch und thermisch kontaktiert wird, insbesondere in einem Presspack-Gehäuse untergebracht ist, sind Federelemente (18, 19) zur Aufrechterhaltung des Kontaktdruckes im Normalbetrieb vorgesehen.

Der Verlust an Federkraft im Kurzschlussfall wird dadurch ausgeglichen, dass mindestens ein Teil der Federelemente (18, 19) aus einer Formgedächtnislegierung (SMA-Werkstoff) bestehen, und bei einem Kurzschluss im Hochleistungshalbleiterbauelement (13) den Kontaktdruck aufrechterhalten. Dies kann entweder dadurch geschehen, dass die Federn aus SMA-Werkstoffen die Federkraft im Kurzschlussfall erhöhen, oder dass infolge der Superplastizität die Federkraft über einen weiten Federweg im wesentlichen konstant gehalten wird.

## Beschreibung

### TECHNISCHES GEBIET

Die vorliegende Erfindung bezieht sich auf das Gebiet der Leistungselektronik. Sie betrifft eine Einspannvorrichtung für wenigstens ein Hochleistungshalbleiterbauelement gemäss dem Oberbegriff des Anspruchs 1.

Eine solche Einspannvorrichtung ist z.B. aus der US-A-4,672,422 bekannt.

### STAND DER TECHNIK

Es sind seit langem Hochleistungshalbleiterbauelemente bekannt, bei denen ein oder mehrere aktive Halbleiterchip(s) in einem geschlossenen Gehäuse zwischen metallischen Scheiben angeordnet und durch beidseitigen Druck von aussen elektrisch und thermisch kontaktiert werden (sog. Presspack-Gehäuse). Beispiele für derartige Presspack-Module sind z.B. in der US-A-5,726,466 oder der US-A-5,278,434 offenbart.

In heutigen Presspack-Modulen wird der Druck auf den Halbleiterchip in einer entsprechenden Einspannvorrichtung üblicherweise durch einen Stapel von Tellerfedern aufgebaut. Sie üben im Normalbetrieb eine Kraft in der Grössenordnung von 500 - 1000 N auf den Halbleiterchip aus.

Fällt ein Chip (elektrisch) aus und geht in den Kurzschlusszustand (sog. Short Circuit Failure Mode oder kurz SCFM) über, so konzentriert sich der ganze Strom des Moduls auf den defekten Chip. Als Folge davon schmelzen bei Nennstrombedingungen Teile des Si-Chips auf und legieren mit den Kontaktpartnern, insbesondere den Druck ausübenden metallischen Scheiben. Andere Teile zeigen unter der stark erhöhten Betriebstemperatur des SCFM-Zustandes ein ausgeprägtes Kriechverhalten. Dadurch expandieren die Tellerfedern und die Kraft nimmt ab. Die Deformation kann sogar den zur Verfügung stehenden Federweg überschreiten, so dass die Kraft auf Null absinkt.

Die Kontaktspannung eines Trockenkontakts ist ungefähr umgekehrt proportional zur Wurzel der Anpresskraft. Das führt dazu, dass während des Betriebes im SCFM-Zustand die Kontaktspannung nach einer quasi-stabilen Phase zuerst langsam, dann immer schneller, zu steigen beginnt. Oberhalb einer kritischen Kontaktspannung beginnen Teile des Federpaketes zu schmelzen. Dadurch wird der Strompfad unterbrochen. Da jedoch der äussere Schaltkreis induktiver Natur ist, wird die Spannung sehr rasch ansteigen und ein nächster Chip durch Spannungsüberbelastung ausfallen. Dieser nächste Chip geht dann seinerseits in den SCFM Zustand. Der Prozess setzt sich fort, bis alle Chips im Modul aufgebraucht sind.

Um die Lebensdauer eines Chips im SCFM Zustand möglichst hoch zu halten, ist - insbesondere wenn der Nennstrom eines solchen Moduls in der Grössenordnung von 2000 A liegt - eine fortdauernde Anpresskraft des Kontaktes von minimal 1000 N unabdingbar.

### DARSTELLUNG DER ERFINDUNG

Es ist daher Aufgabe der Erfindung, eine Einspannvorrichtung für druckkontaktierte Hochleistungshalbleiterbauelemente zu schaffen, bei welcher ein Abfall der Normalkraft auf den Chip im Kurzschluss(SCFM)-Zustand sicher vermieden wird.

Die Aufgabe wird durch die Gesamtheit der Merkmale des Anspruchs 1 gelöst. Der Kern der Erfindung besteht darin, mindestens einen Teil der Federelemente aus Werkstoffen herzustellen die zur Gruppe der Formgedächtnislegierungen (Shape Memory Alloy, SMA) gehören. Aufgrund der besonderen Eigenschaften der Formgedächtnislegierungen ist es möglich, auf einfache Weise auch im Kurzschlussfall in der Einspannvorrichtung eine ausreichend Kraft auf das Leistungshalbleiterbauelement auszuüben bzw. aufrechtzuerhalten.

Eine für die Erfindung geeignete erste Gruppe von SMA Werkstoffen zeichnet sich dadurch aus, dass die Elastizitätskonstante bei einem Phasenübergang von einer Tieftemperaturphase (im normalen Betriebszustand) zu einer Hochtemperaturphase (im SCFM Betriebszustand) wesentlich zunimmt.

Eine bevorzugte Ausgestaltung der erfindungsgemässen Einspannvorrichtung ist daher dadurch gekennzeichnet, dass sich der Werkstoff im Temperaturbereich, der im Normalbetrieb vorherrscht, in einem ersten Zustand befindet und bei einer durch einen Kurzschlussstrom erhöhten Temperatur in einen zweiten Zustand mit gegenüber dem ersten Zustand wesentlich erhöhter Federkraft übergeht. Der Phasenübergang erfolgt also durch die Temperaturerhöhung, die mit dem Kurzschluss verbunden ist.

Eine bevorzugte Weiterbildung dieser Ausgestaltung zeichnet sich dadurch aus, dass das mindestens eine Federelement aus dem Werkstoff aus der Gruppe der Formgedächtnislegierungen im ersten Zustand völlig zusammengedrückt ist und erst im zweiten Zustand expandiert. Dadurch entsteht ein zusätzlicher Federweg und eine Erhöhung der Federkraft. Es ist aber auch denkbar, dass das wenigstens eine Federelement bereits im Normalzustand zum Federweg beiträgt und durch den Phasenübergang die Federkraft erhöht.

Eine andere Ausgestaltung der Einspannvorrichtung nach der Erfindung zeichnet sich dadurch aus, dass die Federelemente Tellerfedern sind. Hierbei sind Tellerfedern aus normalen Federwerkstoffen und Tellerfedern aus Formgedächtnislegierungen in einem gemeinsamen Federstapel angeordnet. Hierdurch ergibt sich eine funktionssichere, einfache und wirkungsvolle Druckerzeugung, die platzsparend ist und sich leicht in herkömmliche Einspannvorrichtungen integrieren lässt

Eine für die Erfindung geeignete zweite Gruppe von SMA-Werkstoffen zeigt das Phänomen der Superplastizität. Im superplastischen Zustand bleibt die Federkraft einer Feder über einen beträchtlichen Federweg nahezu unabhängig vom Federweg, während in einer normalen Feder die Kraft proportional zum Weg ist. Damit bleibt die Federkraft bei Ausnützung der Superplastizität auch bei grosser Expansion der Feder immer noch nahezu gleich wie im Ausgangszustand.

Eine weitere bevorzugte Ausgestaltung der erfindungsgemässen Einspannvorrichtung ist daher dadurch gekennzeichnet, dass der Werkstoff das Phänomen der Superplastizität aufweist, und dass die Federelemente in der Einspannvorrichtung so angeordnet sind, dass sich in einem Kurzschlussfall bei Nennstrom das mindestens eine Federelement aus dem Werkstoff aus der Gruppe der Formgedächtnislegierungen im superplastischen Teil der Spannungs-Dehnungs Kennlinie befindet. Auch damit kann erreicht werden, dass die Federkraft trotz der durch Schmelz- und Kriechvorgänge im Kurzschlusszustand hervorgerufenen Expansion nicht wesentlich abnimmt.

Bevorzugt nimmt im superplastischen Bereich die auf das Leistungshalbleiterbauelement wirkende Kraft bei einer Dilatation der Federelemente um 1mm, ausgehend vom nominellen Normalzustand, weniger als 30% ab.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in der Seitenansicht ein vereinfacht dargestelltes Ausführungsbeispiel für eine Einspannvorrichtung nach der Erfindung mit einem Federstapel, der zwei Arten von Tellerfedern enthält, während des Normalbetriebes;
- Fig. 2: die Einspannvorrichtung aus Fig. 1 im Kurzschlussfall mit den aktivierten zweiten Tellerfedern; und
- Fig. 3: ein schematisiertes Diagramm für die bei den zweiten Tellerfedern stattfindende Kraft-Weg-Aenderung beim Uebergang vom Normalbetrieb (Kurve A; Martensitphase) zum Kurzschlussfall (Kurve B; Austenitphase).

### WEGE ZUR AUSFÜHRUNG DER ERFINDUNG

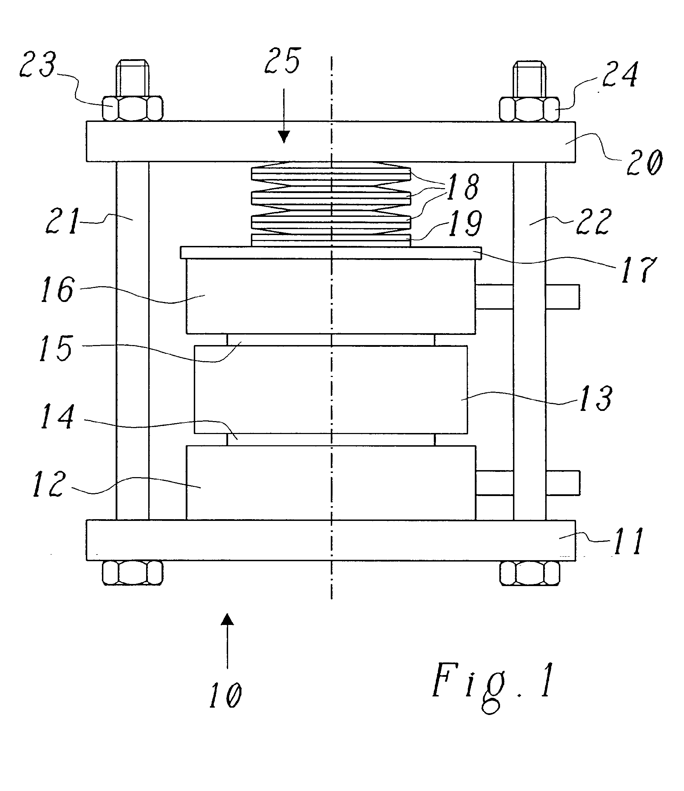

In Fig. 1 ist in der Seitenansicht ein vereinfacht dargestelltes Ausführungsbeispiel für eine Einspannvorrichtung nach der Erfindung wiedergegeben. Die Einspannvorrichtung 10 umfasst eine untere Halteplatte 11 und eine obere Halteplatte 20, die durch Bolzen 21, 22 mit Gewinden und entsprechenden Muttern 23, 24 miteinander verbunden (verschraubt) sind. Zwischen der unteren und oberen Halteplatte 11 bzw. 20 ist ein Stapel angeordnet und gehalten, der im dargestellten Beispiel aus einem Hochleistungshalbleiterbauelement 13 im Presspack-Gehäuse und einer unteren und oberen Kühldose 12 bzw. 16 besteht. Die Kühldosen 12, 16 sind von einer Kühlflüssigkeit durchflossen und führen die im Normalbetrieb entstehende Verlustwärme aus dem Hochleistungshalbleiterbauelement 13 ab. Sie können gleichzeitig auch als Stromanschlüsse ausgelegt sein. Es ist selbstverständlich im Rahmen der Erfindung auch denkbar, innerhalb des Stapels mehrere Hochleistungshalbleiterbauelemente und Kühldosen abwechselnd übereinander anzuordnen und die Bauelemente in Serie zu schalten, oder das Hochleistungshalbleiterbauelement 13 mit nur einer Kühldose oder mit anderen Kühleinrichtungen zu kombinieren.

Beim Hochleistungshalbleiterbauelement 13 wird der interne (nicht sichtbare) Halbleiterchip thermisch und elektrisch durch axial hervorstehende Elektrodenplatten 14, 15 druckkontaktiert. der dafür notwendige Druck wird durch einen Federstapel 25 aus ersten Tellerfedern 18 erzeugt und im Normalbetrieb aufrechterhalten. Der Federstapel 25 ist im dargestellten Beispiel zwischen der oberen Kühldose 16 und der oberen Halteplatte 20 angeordnet und von der oberen Kühldose 15 zur Vermeidung eines Kurzschlusses durch eine Isolierplatte 17 elektrisch isoliert. Es ist aber auch denkbar, jedem der Bolzen 21, 22 einen eigenen Federstapel zuzuordnen.

Gemäss einer bevorzugten Ausgestaltung der Erfindung sind nun im Federstapel 25 neben den ersten Tellerfedern 18 aus herkömmlichem Federmaterial zweite Tellerfedern 19 aus einer Formgedächtnislegierung (Shape Memory Alloy SMA) vorgesehen. SMAs befinden sich unterhalb einer kritischen Temperatur in einer Martensitstruktur. In der Martensitphase sind sie relativ weich und leicht verformbar. Beim Erwärmen gehen die SMA durch einen Phasenübergang (schwach erster Ordnung) in eine höher symmetrische Austenitphase. Dabei verformen sie sich zurück in den ursprünglichen Zustand. Die Austenitphase hat einen hohen E-Modul. Stapel von SMA-Tellerfedern mit unterschiedlicher Uebergangstemperatur sind bereits zur stufenweisen Druckerzeugung in einem anderen Zusammenhang eingesetzt worden (US-A-4,897,006). Desweiteren ist von Braunovic und Labrecque in IEEE Transactions on Components, Packaging and Manufacturing Technology A, 19, 295 (1996) vorgeschlagen worden, Tellerfedern (sog. Belleville washers) auf SMA Basis für stationäre elektrische Kontakte einzusetzen.

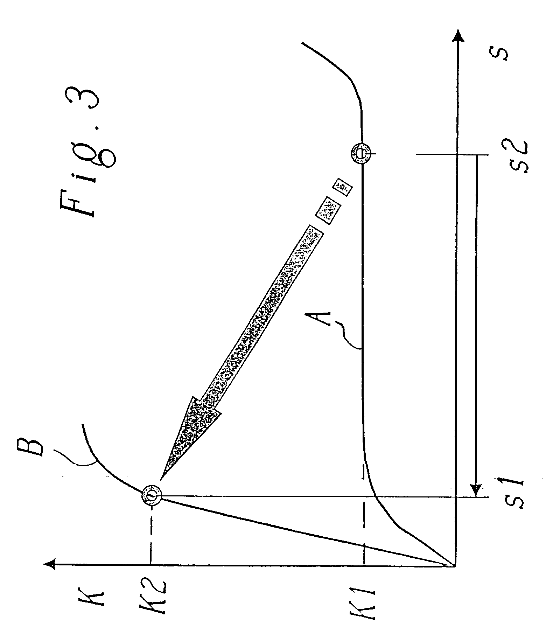

Das SMA-Material der zweiten Tellerfedern 19 wird nun so gewählt, dass es bei normalen Betriebszuständen des Hochleistungshalbleiterbauelements 13 in der Martensitphase vorliegt. Das heisst, die Uebergangstemperatur von der Martensitin die Austenitphase muss oberhalb der maximalen Betriebstemperatur der Federn im intakten Zustand des Hochleistungshalbleiterbauelements 13 liegen. Weiterhin werden die zweiten Tellerfedern 19 so ausgelegt, dass sie in der Martensitphase voll komprimiert (flach) sind (Fig. 1; Kurve A in Fig. 3; Feder eingedrückt um Federweg s2; Federkraft K1)). Die Federwirkung wird also im Normalbetrieb vollständig von den ersten (normalen) Tellerfedern 18 übernommen. Dadurch stellen sich keine Zuverlässigkeitsprobleme in Bezug auf das Altern der Federkonstante in der Martensitphase.

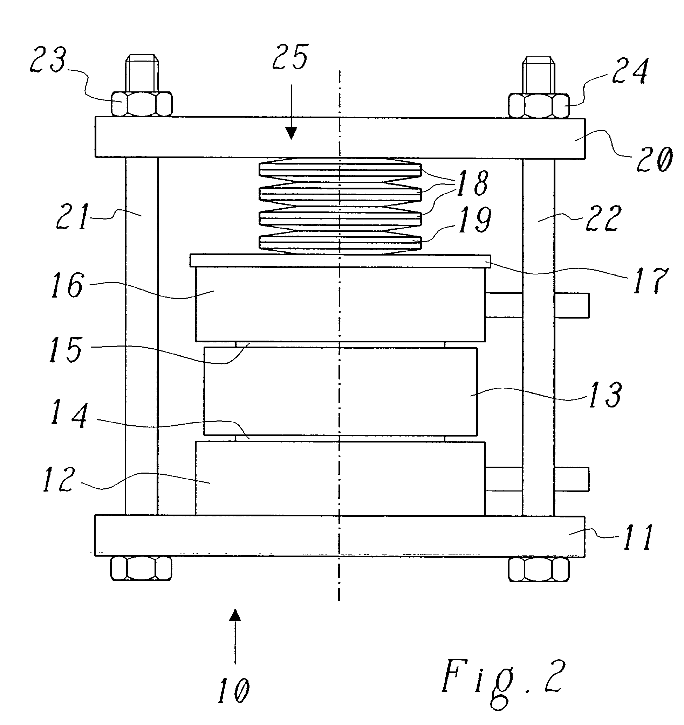

Im Kurzschluss(SCFM)-Fall fliesst der volle Strom durch den Halbleiterchip innerhalb des Hochleistungshalbleiterbauelements 13. Die damit verbundene Erwärmung treibt die aus SMA hergestellten zweiten Tellerfedern 19 in die Austenitphase (Pfeil in Fig. 3; Kurve B). Damit steigt der E-Modul dramatisch an, die Tellerfedern 19 expandieren (in Fig. 3 Feder nur noch eingedrückt um Federweg s1; Federkraft K2) und erhöhen den Druck und den Federweg (Fig. 2). Dadurch kann die mit dem Kurzschlussfall einhergehende axiale "Verkürzung" des Hochleistungshalbleiterbauelements 13 ausgeglichen werden. Es ist jedoch auch denkbar, dass die zweiten Tellerfedern 19 bereits im Normalzustand zum Federweg beitragen (also nicht vollständig zusammengedrückt sind) und durch den Phasenübergang die Federkraft erhöhen.

Eine andere Möglichkeit besteht darin, die zweiten Tellerfedern 19 (oder alle Federelemente) aus einem Werkstoff aus der Gruppe der Formgedächtnislegierungen herzustellen, der das Phänomen der Superplastizität aufweist. Die Federelemente werden dann so ausgelegt und in der Einspannvorrichtung 10 angeordnet, dass sie sich in einem Kurzschlussfall bei Nennstrom im superplastischen Teil der Spannungs-Dehnungs-Kennlinie befinden. Besonders günstig ist es dabei, wenn im superplastischen Bereich die auf das Hochleistungshalbleiterbauelement 13 wirkende Kraft bei einer Dilatation der Federelemente um 1mm, ausgehend vom nominellen Normalzustand, weniger als 30% abnimmt. Auch hierdurch ist es möglich, eine durch den Kurzschluss hervorgerufene Expansion im Federstapel zuzulassen, ohne die notwendige Federkraft zu verlieren.

Durch die beschriebene Ausbildung der Einspannvorrichtung 10 ergeben sich die folgenden Vorteile:
- eine Entkopplung des Drucks im Normalzustand (begrenzt durch Zuverlässigkeitsforderungen) vom Druck im Kurzschluss(SCFM)-Zustand
- eine Senkung des Kontaktwiderstandes durch stark erhöhten Druck im Kurzschluss(SCFM)-Zustand
- eine Erhöhung des Federwegs.

### BEZUGSZEICHENLISTE

- 10: Einspannvorrichtung
- 11,20: Halteplatte
- 12,16: Kühldose
- 13: Hochleistungshalbleiterbauelement (im Presspack-Gehäuse)
- 14,15: Elektrodenplatte (scheibenförmig)
- 17: Isolierplatte
- 18,19: Tellerfeder
- 21,22: Bolzen
- 23,24: Mutter
- 25: Federstapel

## Patentansprüche

1. Einspannvorrichtung (10) für mindestens ein Hochleistungshalbleiterbauelement (13), auf welches Hochleistungshalbleiterbauelement (13) in der Einspannvorrichtung (10) mittels Federelementen (18, 19) eine Kraft übertragen wird, **dadurch gekennzeichnet, dass** mindestens eines der Federelemente (19) aus einem zur Gruppe der Formgedächtnislegierungen gehörenden Werkstoff besteht.

2. Einspannvorrichtung nach Anspruch 1, **dadurch gekennzeichnet, dass** sich der Werkstoff im Temperaturbereich, der im Normalbetrieb vorherrscht, in einem ersten Zustand befindet und bei einer durch einen Kurzschlussstrom erhöhten Temperatur in einen zweiten Zustand mit gegenüber dem ersten Zustand wesentlich erhöhter Federkraft übergeht.

3. Einspannvorrichtung nach Anspruch 2, **dadurch gekennzeichnet, dass** das mindestens eine Federelement (19) aus dem Werkstoff aus der Gruppe der Formgedächtnislegierungen im ersten Zustand völlig zusammengedrückt ist und erst im zweiten Zustand expandiert.

4. Einspannvorrichtung nach einem der Ansprüche 1 bis 3, **dadurch gekennzeichnet, dass** die Federelemente Tellerfedern (18, 19) sind.

5. Einspannvorrichtung nach Anspruch 1, **dadurch gekennzeichnet, dass** der Werkstoff das Phänomen der Superplastizität aufweist, und dass die Federelemente (18, 19) in der Einspannvorrichtung (10) so angeordnet sind, dass sich in einem Kurzschlussfall bei Nennstrom das mindestens eine Federelement (19) aus dem Werkstoff aus der Gruppe der Formgedächtnislegierungen im superplastischen Teil der Spannungs-Dehnungs-Kennlinie befindet.

6. Einspannvorrichtung nach Anspruch 5, **dadurch gekennzeichnet, dass** im superplastischen Bereich die auf das Hochleistungshalbleiterbauelement (13) wirkende Kraft bei einer Dilatation der Federelemente (18, 19) um 1mm, ausgehend vom nominellen Normalzustand, weniger als 30% abnimmt.
